# DEMANDE DE BREVET EUROPEEN

(11) **EP 1 311 065 A1**
(43) Date de publication de la demande: **14.05.2003**
(21) Numéro de dépôt: 02079625.6
(22) Date de dépôt: 06.11.2002
(51) Int. Cl.: H03J 7/04, H03L 5/00

(54) **Circuit d'accord comprenant un convertisseur de tension**

(30) Priorité: 13.11.2001 FR 0114667
(71) Demandeur: Koninklijke Philips Electronics N.V., 5621 BA Eindhoven (NL)
(72) Inventeur: Pruvost, Xavier, Société Civile S.P.I.D., 75008 Paris (FR)
(74) Mandataire: Chaffraix, Jean

(57) **Abrégé**

L'invention concerne un tuner pour convertir un signal radio-fréquence en un signal de fréquence intermédiaire, ledit tuner comprenant un convertisseur de tension délivrant un signal de commande, un mélangeur associé à un oscillateur commandé en tension par ledit signal de commande. L'invention est caractérisée en ce que ledit convertisseur de tension comprend :
- un circuit auto-oscillant générant un signal de tension alternative de niveau variable,
- des moyens de redressement pour délivrer un signal de tension continue de niveau variable à partir dudit signal de tension alternative de niveau variable,
- un circuit additionnel pour réduire les variations du coefficient d'amortissement dudit circuit auto-oscillant, ledit circuit additionnel recevant ledit signal de tension continue de niveau variable et délivrant ledit signal de commande.

L'invention présente une solution peu coûteuse ayant des performances améliorées en termes de pureté spectrale, facilité d'implémentation, et de stabilité de régulation dudit signal de fréquence intermédiaire.

## Description

### DOMAINE DE L'INVENTION

L'invention concerne un tuner pour convertir un signal radio-fréquence en un signal de fréquence intermédiaire, ledit tuner comprenant un convertisseur de tension délivrant un signal de commande, un mélangeur associé à un oscillateur commandé en tension par ledit signal de commande.

L'invention a de nombreuses applications dans les systèmes de réception et de démodulation de signaux radio-fréquence.

### ARRIERE PLAN TECHNOLOGIQUE DE L'INVENTION

Un tuner est couramment utilisé dans des appareils de type radio, téléviseur, ou plus généralement dans des appareils traitant des signaux d'entrée modulés véhiculant des données multimédias. Les tuners ont pour rôle de sélectionner dans un signal radio-fréquence d'entrée un signal de données à une certaine fréquence, et de convertir le signal sélectionné en un signal de sortie de fréquence intermédiaire en vue notamment d'une amplification et d'une démodulation.

La figure 1 décrit les différents blocs structurels d'un tuner connu de l'art antérieur via le brevet des Etats-Unis d'Amérique no. 5,742,898.

Le tuner effectue via le mélangeur 103 la conversion du signal radio-fréquence d'entrée 101 en un signal de sortie de fréquence intermédiaire 102. Le mélangeur 103 reçoit le signal de sortie 104 généré par un oscillateur 105, ce dernier étant commandé en tension par un signal de commande 106. La fréquence du signal de sortie 104 dudit oscillateur dépend d'un signal de consigne 107 appliqué au tuner.

Le mélangeur 103 effectue une multiplication du signal d'entrée 101 avec ledit signal de sortie 104, entraînant sur le signal 101 un décalage fréquentiel d'une valeur égale à la fréquence dudit signal 104.

Pour que la fréquence du signal de sortie 104 se stabilise - c'est-à-dire pour garantir la stabilité de la fréquence du signal de fréquence intermédiaire 102 - et soit le reflet du signal de consigne 107, des moyens de régulation sont prévus. Ces moyens de régulation comprennent notamment un comparateur 110 pour comparer la fréquence d'un signal de référence 108 avec un signal 111 dont la fréquence est un sous-multiple de la fréquence du signal 104, la valeur du sous-multiple étant déterminée par le signal de consigne 107 appliqué à un diviseur de fréquence 109. Le comparateur délivre un signal de déphasage 112 proportionnel au déphasage entre les signaux 108 et 111, ledit signal de déphasage étant appliqué à un régulateur 113. Le régulateur 113 délivre un signal d'erreur 114 à un convertisseur de tension 115 ayant pour but de générer ledit signal de commande 106.

Le convertisseur de tension 115 génère le signal de commande 106 dont le niveau dépend du niveau dudit signal d'erreur 114. Suivant la valeur instantanée dudit déphasage, donc du signal d'erreur 114, pour que le signal de sortie 104 reflète la valeur du signal de consigne 107, le niveau du signal de commande 106 est modifié pour faire varier la fréquence du signal de sortie 104 jusqu'à ce que ledit déphasage devienne nul. Un tel convertisseur de tension permet de délivrer des tensions de commande dont le niveau varie typiquement entre 0 et 30 volts à partir d'une source de tension continue 116 de quelques volts.

Le tuner décrit dans le document de l'art antérieur présente un certain nombre de limitations.

Pour pouvoir délivrer des tensions de commande sur une telle étendue, le convertisseur de tension comprend notamment des moyens de génération d'un signal de tension alternative de niveau variable. Lesdits moyens de génération d'un signal alternatif sont composés d'un oscillateur numérique générant un signal numérique de fréquence et d'amplitude paramétrables. Ledit signal numérique est alors converti au moyen d'un convertisseur numérique analogique pour générer ledit signal de tension alternative de niveau variable via un transformateur. Ledit signal de tension alternative est ensuite redressé via des moyens de redressement pour obtenir le signal de commande 106. Les moyens de génération de ladite tension de commande à partir d'une source de tension continue de quelques volts mis en oeuvre sont donc coûteux, ce qui est fortement limitatif dans le cadre d'applications grand public.

### RESUME DE L'INVENTION

L'invention a pour but de proposer un tuner mettant en oeuvre un convertisseur de tension à faible coût et présentant une grande stabilité de fonctionnement.

Pour cela, le tuner est remarquable en ce que le convertisseur de tension comprend :
- un circuit auto-oscillant générant un signal de tension alternative de niveau variable,
- des moyens de redressement pour délivrer un signal de tension continue de niveau variable à partir dudit signal de tension alternative de niveau variable,
- un circuit additionnel pour réduire les variations du coefficient d'amortissement dudit circuit auto-oscillant, ledit circuit additionnel recevant ledit signal de tension continue de niveau variable et délivrant ledit signal de commande.

La mise en oeuvre d'un circuit auto-oscillant en tant que générateur d'un signal de tension alternative est peu coûteuse puisqu'elle ne nécessite qu'un transistor et quelques composants passifs. Le circuit auto-oscillant est un circuit résonnant générant un signal de tension alternative redressé au moyen d'un pont redresseur,

Le convertisseur de tension délivrant un courant de niveau constant via lesdits moyens de redressement, son impédance de charge varie dans une large étendue dans la mesure où le niveau du signal de tension continue peut prendre des valeurs entre 0 et 30 volts. Cette variation d'impédance de charge entraîne une modification du facteur d'amortissement du circuit auto-oscillant si rien n'est prévu. Le circuit additionnel permet de réduire fortement les variations du coefficient d'amortissement du circuit auto-oscillant lorsque le niveau du signal de tension continue varie. De cette façon, l'amortissement du circuit auto-oscillant reste à un niveau faible. Le fonctionnement du circuit auto-oscillant devient fortement indépendant du niveau du signal de tension continue. Cette solution conduit donc à une plus grande stabilité de fonctionnement.

D'autre part, il devient aisé de dimensionner les éléments d'un tel convertisseur de tension pour qu'il fonctionne dans le régime linéaire puisque les variations d'impédance de charge n'ont que peu d'influence sur son fonctionnement. A contrario d'un régime non linéaire, un avantage supplémentaire à ce que les éléments du tuner fonctionnent en régime linéaire est d'éviter la génération d'harmoniques ou de signaux parasites dans le tuner, et donc de garantir un signal de fréquence intermédiaire de spectre fréquentiel non "pollué".

L'invention est aussi remarquable en ce que le circuit additionnel comprend des moyens de régulation pour asservir la phase dudit signal de fréquence intermédiaire à un signal de consigne, et le courant délivré par ledit convertisseur de tension à une valeur de référence, ledit convertisseur de tension comprenant des moyens de variation du niveau dudit signal de commande en fonction d'un signal d'erreur généré par la boucle de régulation.

De par ses caractéristiques permettant un contrôle du signal de tension continue qu'il génère, le convertisseur de tension peut ainsi facilement s'intégrer pour garantir la stabilité en phase et en fréquence du signal de fréquence intermédiaire.

L'invention est aussi remarquable en ce que le tuner comprend le circuit additionnel composé d'un filtre passe-bas en série avec une résistance.

Cela constitue une solution économique au problème de la réduction des variations du coefficient d'amortissement du circuit oscillant.

L'invention concerne également un appareil de type boîtier de réception, ainsi qu'un téléviseur, qui implémentent un tuner ayant les caractéristiques décrites ci-dessus et permettant la conversion d'un signal radio-fréquence en un signal de fréquence intermédiaire.

### BREVE DESCRIPTIONS DES DESSINS

Ces aspects de l'invention ainsi que d'autres aspects plus détaillés apparaîtront plus clairement grâce à la description suivante, faite en regard des dessins ci-annexés, le tout donné à titre d'exemple non limitatif, dans lesquels :
La figure 1 est un schéma de principe d'un tuner,
La figure 2 représente un mode de réalisation d'un tuner selon l'invention,
La figure 3 illustre un appareil de réception d'un signal radio-fréquence implémentant un tuner selon l'invention.

### DESCRIPTION DE MODES DE REALISATION DE L'INVENTION

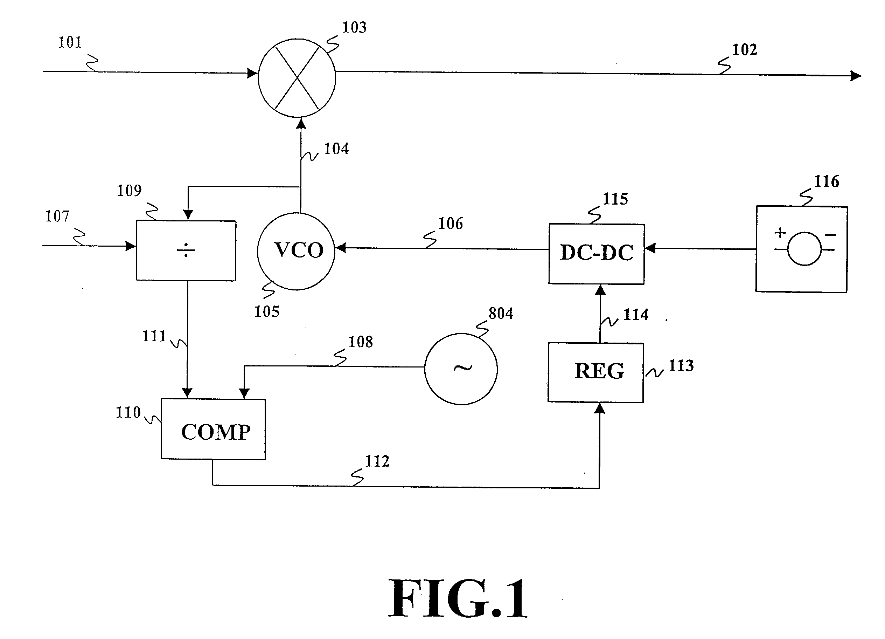

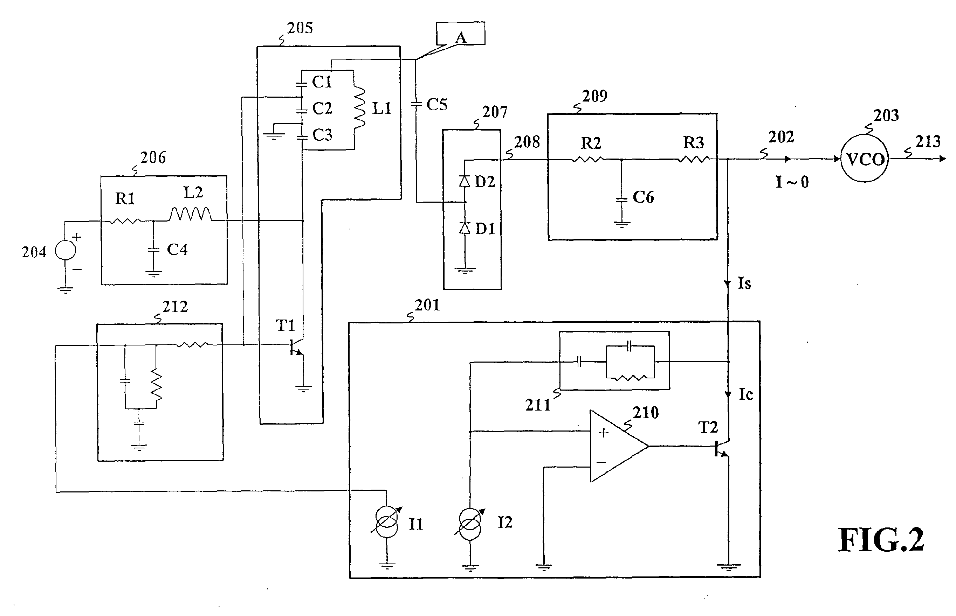

La figure 2 représente un mode de réalisation d'un tuner selon l'invention. Son principe général de fonctionnement est similaire à celui décrit à la figure 1. Pour des raisons de clarté, seuls sont détaillés les éléments caractéristiques de l'invention. En particulier, les moyens de régulation 201 permettant de stabiliser la phase (ainsi que la fréquence) du signal de sortie de l'oscillateur commandé en tension, ainsi que les moyens de régulation de la valeur du courant Is délivré par le convertisseur de tension sont représentés de façon schématique.

Le tuner selon l'invention comprend un convertisseur de tension permettant de délivrer un signal de tension continue variable 202, dit signal de commande, à l'oscillateur commandé en tension 203, à partir d'une source de tension continue 204 de quelques volts.

Le convertisseur de tension comprend un circuit auto-oscillant 205 de type Colpitts constitué des condensateurs C1-C2-C3, de l'inductance L1, et du transistor T1. L'association des éléments C2-C3-T1 constitue une impédance négative permettant au circuit résonnant 205 d'osciller librement. L'amplitude des oscillations est déterminée par la valeur du courant circulant dans le collecteur de T1, donc par la valeur du courant dans la base de T1, dans la mesure où le transistor T1 fonctionne en régime linéaire. A une valeur de courant dans la base du transistor T1 correspond donc une variation de la valeur de ladite résistance négative, ce qui entraîne une variation de l'amplitude des oscillations à la sortie du circuit auto-oscillant 205 au point A. L'amplitude des oscillations au point A est d'autant plus grande que de ladite résistance négative a une forte valeur en valeur absolue. En d'autres termes, a une valeur de courant dans la base du transistor T1 correspond donc une valeur du coefficient d'amortissement des oscillations. Les éléments du circuit oscillant sont dimensionnés pour que la fréquence de résonance du circuit auto-oscillant soit de préférence de l'ordre du méga-Hertz.

Via un circuit 206 effectuant un filtrage passe-bas constitué de la cellule R1-C4, et un lissage du courant par l'inductance L2, la tension continue 204 est injectée dans le collecteur du transistor T1. La tension continue 204, de l'ordre du volt (typiquement 5 volts), est la tension à partir de laquelle le signal de tension continue variable 202 est généré, via le circuit auto-oscillant 205.

Via une capacité de liaison C5, les oscillations du circuit auto-oscillant 205 sont redressées au moyen du circuit 207. Le circuit 207 est constitué par deux diodes D1-D2 effectuant un décalage de tension vers le haut de sorte que les parties basses des oscillations soient remontées au niveau zéro. Un signal de tension 208 de valeur moyenne fonction du niveau du courant de base dans le transistor T1 est ainsi délivré. Un circuit additionnel 209 reçoit le signal 208 pour délivrer ledit signal de tension 202. Ce circuit est constitué de la cellule R2-C6 jouant le rôle de filtre passe-bas pour notamment atténuer les fluctuations du signal de tension 208. A la sortie de la cellule R2-C6 est disposée une résistance R3 permettant de limiter l'impédance de charge du signal de tension 208.

Avec un tel convertisseur de tension, un signal de tension continue 202 dont le niveau peut varier typiquement entre 0 et 30 volts peut être obtenu à partir d'une source de tension 204 ayant un niveau typiquement de 5 volts, tout en générant un courant Is d'une valeur de l'ordre de 100µA.

Dans un mode de réalisation préféré, les moyens de régulation 201 comprennent deux boucles de régulation :
- une première boucle permettant d'asservir la phase du signal de sortie 213 de l'oscillateur commandé en tension, en régulant le niveau du signal de tension 202 à une valeur constante. Pour cela, des moyens permettent de délivrer un courant I2 proportionnel au déphasage entre un signal de référence et le signal de sortie 213 de l'oscillateur 203 commandé en tension par le signal de tension 202. Par exemple, ces moyens peuvent être de type "charge pump circuit" (de l'anglais circuit à pompe de charge) délivrant un courant plus ou moins élevé suivant que les deux signaux sont en avance ou en retard de phase l'un par rapport à l'autre. Le courant I2 est injecté dans un circuit intégrateur actif constitué du comparateur 210, du transistor T2 et du filtre de rétroaction 211. A l'équilibre, c'est-à-dire lorsque les deux signaux sont en phase, le courant I2 devient nul, et le courant Ic dans le collecteur du transistor T2 est quasiment identique au courant Iref d'une source de courant de référence (non représentée).
- une deuxième boude pour asservir la valeur du courant Ic à une valeur de courant de référence. Pour cela, un courant I1 proportionnel à la différence entre Ic et Iref est généré et est injecté via un filtre 212 dans la base du transistor T1. Le courant I1 constitue donc un signal d'erreur. Le filtre 212 est ici un filtre du troisième ordre permettant à la fois une régulation stable ainsi qu'une bonne réjection du signal généré par le circuit auto-oscillant 205. Le transistor T1 permet donc de faire varier l'amplitude des oscillations du circuit auto-oscillant au point A, c'est-à-dire aussi l'amplitude du signal de tension 202, en fonction d'une fraction du courant I1 injecté dans sa base. La stabilité de la boucle de régulation permet donc de garantir la stabilité de la fréquence du signal de sortie 213, quelle que soit la valeur du signal de tension 202.

A l'équilibre, le courant Is circulant dans le circuit additionnel 209 est égal au courant Ic, et sa valeur est quasiment égale au courant Iref de la source de courant de référence. Le niveau du signal de tension 202 pouvant varier typiquement entre 0 et 30 volts, le circuit additionnel 209 limite les variations de l'impédance de charge du circuit auto-oscillant 205, donc limite aussi les variations du facteur d'amortissement du circuit auto-oscillant 205. Cette limitation du facteur d'amortissement est d'autant plus perceptible pour des faibles niveaux du signal de tension 202. Pour des niveaux élevés du signal de tension 202, le circuit additionnel 209 en association avec le circuit redresseur 207 se comporte comme un détecteur de tension crête à crête, tandis qu'il se comporte comme un détecteur de valeur moyenne de tension pour les faibles niveaux du signal de tension 202.

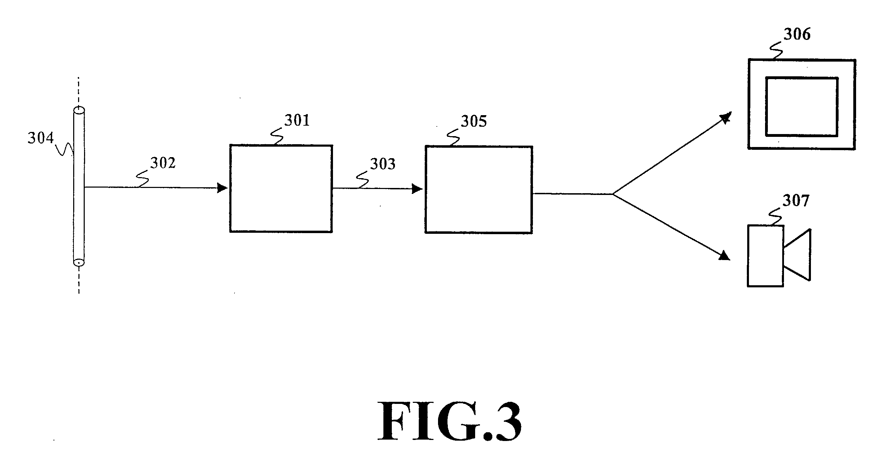

La figure 3 illustre un appareil implémentant un tuner 301 selon l'invention tel que décrit à la figure 2. Cet appareil est dédié à la réception d'un signal radio-fréquence 302 et à sa conversion en un signal de fréquence intermédiaire 303.

Par exemple, cet appareil est de type boîtier de réception (en anglais "set-top box") dédié à la réception d'un signal audio-vidéo radio-fréquence 302 transmis via un réseau câblé 304. Le signal de fréquence intermédiaire 303 délivré par le tuner selon l'invention est par exemple par la suite amplifié et démodulé par les moyens de traitement 305, en vue d'une exploitation via des moyens de type écran 306 et haut-parleurs 307.

Le tuner selon l'invention peut aussi être implémenté dans un téléviseur.

## Revendications

1. Tuner pour convertir un signal radio-fréquence en un signal de fréquence intermédiaire, ledit tuner comprenant un convertisseur de tension délivrant un signal de commande, un mélangeur associé à un oscillateur commandé en tension par ledit signal de commande, **caractérisé en ce que** ledit convertisseur de tension comprend :
- un circuit auto-oscillant générant un signal de tension alternative de niveau variable,
- des moyens de redressement pour délivrer un signal de tension continue de niveau variable à partir dudit signal de tension alternative de niveau variable,
- un circuit additionnel pour réduire les variations du coefficient d'amortissement dudit circuit auto-oscillant, ledit circuit additionnel recevant ledit signal de tension continue de niveau variable et délivrant ledit signal de commande.

2. Tuner selon la revendication 1 **caractérisé en ce qu'**il comprend des moyens de régulation pour asservir la phase dudit signal de fréquence intermédiaire à un signal de consigne, et le courant délivré par ledit convertisseur de tension à une valeur de référence, ledit convertisseur de tension comprenant des moyens de variation du niveau dudit signal de commande en fonction d'un signal d'erreur généré par la boucle de régulation.

3. Tuner selon la revendication 2 **caractérisé en ce que** le circuit additionnel comprend un filtre passe-bas en série avec une résistance.

4. Boîtier de réception pour recevoir un signal de radio-fréquence **caractérisé en ce qu'**il comprend un tuner selon la revendication 1.

5. Téléviseur comprenant un tuner selon la revendication 1.
